(19)

Europäisches
Patentamt

European
Patent Office

Office européen
des brevets

(11) **EP 3 156 784 A1**

(12) **EUROPEAN PATENT APPLICATION**

(43) Date of publication:
**19.04.2017 Bulletin 2017/16**

(51) Int Cl.:
**G01N 22/00** (2006.01)  **G01R 27/26** (2006.01)

(21) Application number: **15189446.6**

(22) Date of filing: **12.10.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicants:
• **VRIJE UNIVERSITEIT BRUSSEL**
  **1050 Brussel (BE)**
• **M2Wave bvba**
  **1040 Brussel (BE)**

(72) Inventors:
• **STIENS, Johan**
  **2820 Bonheiden (BE)**
• **MATVEJEV, Vladimir**
  **1200 Sint-Lambrechts-Woluwe (BE)**
• **PANDEY, Gokarna**
  **1200 Woluwe-Saint-Lambert (BE)**

(74) Representative: **DenK iP**
  **Leuvensesteenweg 203**
  **3190 Boortmeerbeek (BE)**

(54) **ENHANCED CHARACTERIZATION OF DIELECTRIC PROPERTIES**

(57)    A sensor for sensing a reflection property of a material, the sensor comprising an electromagnetic radiation input means for creating or receiving an electromagnetic radiation signal, a resonator for influencing the electromagnetic radiation input signal, a material holder for holding the material under test, a delay line positioned between the resonance filter and the material holder such that the electromagnetic radiation travels in the delay line after passing the resonance filter and prior to reaching the material under test, when it is positioned in the material holder, and a detection means for detecting a signal reflected by the material under test.

FIG. 5

**Description**

**Field of the invention**

The invention relates to the field of sensing. More specifically it relates to methods and systems for sensing dielectric properties of materials using reflection or transmission measurements.

**Background of the invention**

The dielectric permittivity of a material depends on particular properties such as for example its composition and its temperature. Since physical changes such as moisture loss, protein denaturation, etc. take place during processing for example industrial processing and since these affect the dielectric properties of materials, the process or thereof can be followed by monitoring or evaluating changes in dielectric permittivity.

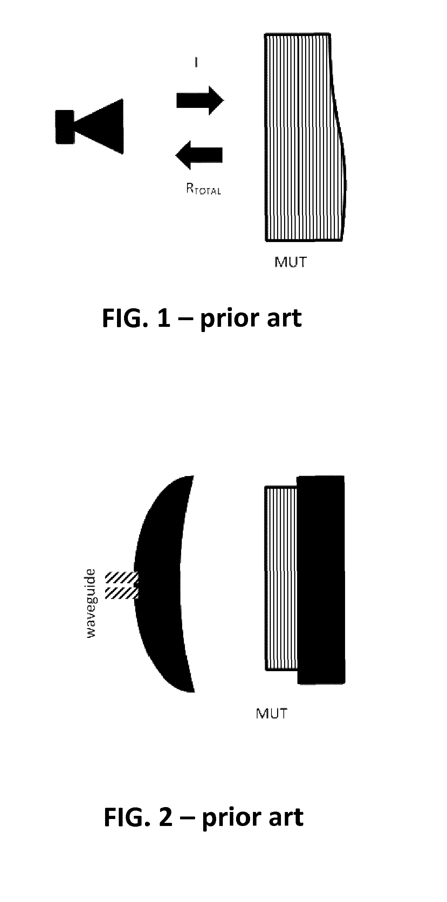

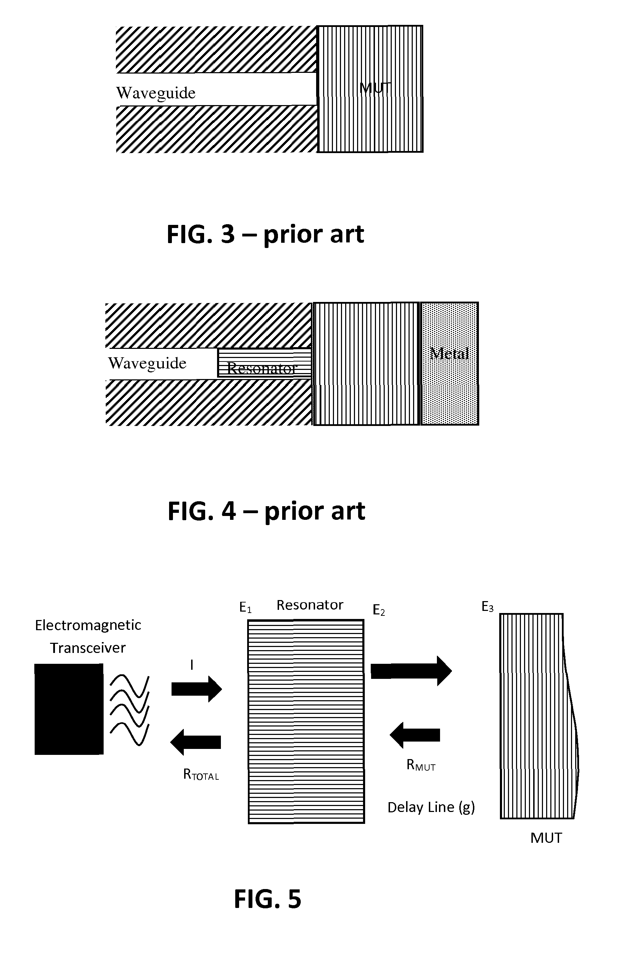

Monitoring or evaluating changes in dielectric permittivity may for example be performed using an electromagnetic measurement system or sensor. One example of a system or sensor for measuring dielectric properties changes in material is based on detection of electromagnetic wave reflection coefficients. Existing sensor solutions measure changes in the reflection coefficient to determine the material properties (e.g. moisture, temperature, overall composition, and etc.). Nevertheless, the changes in reflection coefficient due to material property changes are small and often cannot distinguish subtle change. Existing electromagnetic sensor solutions like free-space electromagnetic measurements often use a simple antenna configuration, as shown in FIG. 1. Open resonators, like a Fabry-Perot require the material under test (MUT) to be loaded into the resonator, as shown in FIG. 2, this imposes conditions on sample size, placement. Similarly, open-ended electromagnetic transmission-lines can be used for material characterization as shown in FIG. 3, but these solutions also do not feature high sensitivity, while transmission line resonators need to be loaded with the material under test (MUT) inside the transmission line. Yet another known configuration is given, wherein a waveguide configuration is used in FIG. 4. The sensors shown in FIG. 1 and FIG. 3 are wideband but are little sensitive to changes of the dielectric permittivity of the material. The sensors in FIG. 2 and FIG. 4 utilize a resonator to enhance the sensitivity of a conventional open-ended probe. A thin layer of MUT is in direct contact with the resonator and is covered with metal, which imposes limitations on MUT.

Consequently, there is still a need for a sensor which allows determining dielectric properties with a high accuracy and resolution.

**Summary of the invention**

It is an object of embodiments of the present invention to provide sensors, systems and methods for determining dielectric property changes of materials with high sensitivity and high accuracy.

It is an advantage of embodiments of the present invention to provide a sensor which is based on detection of reflection or transmission signals but wherein the configuration is adapted such that the changes in an overall reflection or transmission measured are substantially larger than the changes in the reflection or transmission of the material under test, so that an increased sensitivity for the minute change in dielectric permittivity of the material can be obtained.

It is an advantage of embodiments according to the present invention that a sensor system and method can be obtained whereby a process, e.g. industrial process can be followed by instantaneous detection of the changes in dielectric permittivity of a material, using reflection or transmission measurements.

The above objective is accomplished by a method and device according to the present invention.

The present invention relates to a sensor for sensing a reflection or transmission property of a material, the sensor comprising an electromagnetic radiation input means for creating or receiving an electromagnetic radiation signal, a resonator for influencing the electromagnetic radiation input signal, a material holder for holding the material under test, a delay line positioned between the resonance filter and the material holder such that the electromagnetic radiation travels in the delay line after passing the resonance filter and prior to reaching the material under test, when it is positioned in the material holder, and a detection means for detecting a signal reflected by or transmitted through the material under test. It is an advantage of embodiments according to the present invention that small changes in the reflection properties of a material under test, result in larger changes of the reflection coefficient or transmission coefficient measured for the material under test using the particular configuration of the resonance filter, the delay line and the material holder.

The sensor may have a free space configuration. It is an advantage of embodiments according to the present invention that a free-space configuration can be used, whereby little or no limitative conditions are posed on the material under test.

The electromagnetic radiation input means may be an electromagnetic radiation source comprising a transmitter.

The sensor may have a waveguide-based configuration, wherein the electromagnetic radiation input is a waveguide portion wherein electromagnetic radiation can be coupled and wherein the resonance filter is a resonance filter embedded in the waveguide and wherein at least part of the delay line is positioned in the waveguide. It is an advantage of some embodiments of the present invention that for some applications a waveguide-based configuration can be used. The system may comprise a transceiver, functioning both as electromagnetic radiation input means and as detection means.

The resonator may be a high quality factor resonator, with a quality factor larger than 10. The resonator may be a band pass filter.

The length of the delay line may be adjustable so as to be able to adjust the sensor to the material under test to be measured.

The material holder may be adapted for adjusting a position of the material under test, so as to adjust the length of the delay line.

The present invention also relates to the use of a sensor as described above for detection a change in dielectric properties of a material under test.

The present invention furthermore relates to the use of a sensor as described above for monitoring a change in material composition.

The present invention also relates to the use of a sensor as described above for monitoring a process, e.g. an industrial process.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

**Brief description of the drawings**

FIG. 1 - prior art describes a free space configuration for detection of reflection signals, as known in the field.
FIG. 2 - prior art describes an open resonator configuration based on a Fabry-Perot detection of reflection signals, as known in the field.
FIG. 3 - prior art and FIG. 4 - prior art describe waveguide based open-ended electromagnetic transmission-line configurations for measuring reflection signals, as known in the field.
FIG. 5 illustrates a configuration for accurate detection of reflection of a material under test, according to an embodiment of the present invention.
FIG. 6 illustrates an explicit example of a free-space configuration for accurate detection of reflection according to the embodiment as shown in FIG. 5.
FIG. 7 illustrates an explicit example of an open ended electromagnetic transmission-line configuration sensor for detecting of reflection, according to an embodiment as shown in FIG. 6.
FIG. 8a and FIG. 8b illustrate the sensitivity of reflection measurements to changes in dielectric properties for a state of the art reflection measurement configuration (FIG. 8a) and a reflection measurement configuration according to an embodiment of the present invention (FIG. 8b).
FIG. 9 illustrates results for transmission measurements for a liquid with varying alcohol concentration, illustrating advantages of embodiments of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

**Detailed description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to a material under test or MUT, reference is made to the material of interest that is to be identified based on dielectric properties or that is to be monitored for identifying properties of the material during a process, e.g. an industrial process, or that is to be monitored for identifying properties of the process, e.g. an industrial process.

For reflection measurements, the material under test or MUT has a reflection coefficient larger than zero. The reflection coefficient S11 should be larger than 0.

In a first aspect, the present invention relates to a sensor for detecting a dielectric property of a material under test or a change in dielectric properties of a material under test. The dielectric property may for example be a permittivity of a material, a real and/or imaginary dielectric permittivity, a loss tangent, a real and/or imaginary refractive index, relaxation parameters for a dielectric permittivity model such as a Debye, Cole or Havriliak-Negami model whereby the relaxation parameters can for example be time constants or strength, etc. According to embodiments of the present invention, the dielectric property is based on a reflection or transmission measurement of the material under test. It thereby is an advantage of embodiments of the present invention that a configuration is used for measuring reflection or transmission whereby small changes in the reflection or transmission properties of the material under test result in significantly larger changes in the overall reflection or transmission measured, such that detection with a high sensitivity can be used. Changes in dielectric properties can be caused by changes to the material under test and consequently, the systems and methods of the present invention allow to detect or follow material changes. Furthermore, if the material changes are imposed by a change in the environmental conditions or during a process, systems and methods may be suitable for monitoring environmental changes or processes, such as for example industrial processes.

According to embodiments of the present invention, the sensor comprises an electromagnetic radiation input means for creating or receiving an electromagnetic radiation signal. Such an electromagnetic radiation input means may be an electromagnetic radiation source allowing generation of electromagnetic radiation, or it may be a receiving means adapted for receiving an electromagnetic radiation, such as for example a waveguide portion adapted for receiving electromagnetic radiation from a source. The radiation source -which may be part or may not be part of the sensor - may be a conventional radiation source emitting electromagnetic radiation at least at frequencies where the reflection/transmission is most sensitive. The radiation source may for example be an oscillator such as for example backward wave oscillators, IMPATT diodes, Gunn diodes, etc., it may for example be a non-linear frequency converters or Multipliers such as harmonic mixers, balanced mixers, etc., it may be for example a phase locked synthesizer, a voltage controlled oscillator or a nonlinear optical mixer (optics to THz). The frequency range wherein the reflection is measured may depend on the size of the object. The frequency range may be in a microwave frequency range, e.g. between a few MHz up to 10 GHz, which can for example be used for bulky objects, may be in the millimeter wave range, e.g. between 10GHz to 100GHz, or may be in the Terahertz range, e.g. between 100 GHz to 10THz. The radiation source may comprise a radiation antenna. It may be a transmittor or may be a transceiver.

The sensor furthermore comprises a resonator for modifying the electromagnetic radiation input signal. The resonator may be a high quality factor resonator. In some embodiments, the resonator may be a band pass filter. The resonator may be one or more resonant elements. The resonator may be a band-stop filter. The resonator has a quality factor Q larger than 10. The resonance frequency of the filter typically is in the frequency range of interest. The resonator may be under-coupled, critically coupled, or over-coupled. In some embodiments, resonance is caused by the multiple reflections/transmissions at the edges of the resonator.

The sensor also comprises a material holder for holding the material under test (MUT). The material holder may for example be a sample stage, a holder having fixing means for fixing the material on the holder, etc. Advantageously, the material holder allows for displacing the material under test, so that the length of the delay line (which will be further discussed below) can be adjusted.

The sensor according to embodiments of the present invention also comprises a delay line. The delay line is positioned between the resonator and the material holder such that the electromagnetic radiation travels in the delay line after passing the resonance filter and prior to reaching the material under test, when it is positioned in the material holder.

The delay line may have a length g between the resonator and MUT, which may be selected as function of a dielectric property of the material under test, the thickness of the material under test and the operating frequency used. The length of the delay line may for example be a function of the permittivity of the material measured. The length of the delay line g can be expressed as :

$$g = \text{function (frequency, dielectric property, thickness of material under test)}$$

wherein g is the length of the delay line, frequency is the working frequency for the sensing, dielectric property is the dielectric property of the material such as for example it permittivity, and thickness of the material under test is the thickness of the material measured in a direction parallel with the incident radiation.

The sensor furthermore typically comprises an electromagnetic radiation detection means for detecting radiation reflected by the MUT, after again passing through the delay line and the resonator. The detection means may be any suitable type of detection means, such as for example broad-band detectors like Schottky Diode detectors or narrow-band detectors like I/Q mixers, subharmonic mixers, etc. The detection means may comprise or be a receiver. In some embodiments, the source and the detector may comprise common parts, for example a transceiver may be present allowing to emit the electromagnetic radiation towards the MUT and allowing to detect reflected or transmitted electromagnetic radiation.

The sensor furthermore may comprise a processing means or processor for converting a detected reflection signal in a dielectric parameter of the MUT. Such a processing means or processor may be part of the sensor or may be external thereto. In some embodiments, such a processor may comprise or be replaced by a programmed algorithm or a look up table. Other optional component such as for example a memory, processing means, an output means or display for indicating a result, ... may be present, as known by the person skilled in the art. By way of illustration, an example of the configuration of a sensor according to an embodiment of the present invention is shown in FIG. 5. An electromagnetic radiation source is shown, as well as a resonator. The resonance in the resonator typically may be caused by multiple reflections on the resonator edges (E1 and E2) whereby the specific resonance induced is determined by the reflections on the edges and the resonator length. The reflection R on an edge is determined by the impedance mismatch, given by

$$R = \frac{Z1 - Z0}{Z1 + Z0}$$

Impedance on the dielectric resonator edge E2 is determined by the reflection on the edge of MUT (E3) and distance to the MUT (g), as it is given by the following equation:

$$Z_{E2} = \frac{Z_{E2}(1 + \Gamma_{E3} \exp(-2i\beta g))}{(1 - \Gamma_{E3} \exp(-2i\beta g))}$$

where $\Gamma_{E3}$ is the reflection on the MUT edge (E3), which is dependent on the dielectric permittivity property of MUT, and where β is the wave number.

The high sensitivity of the sensor is obtained as follows : small changes of $\Gamma_{E3}$ result in a change in resonator conditions which detunes the resonance and causes a bigger signal change. The resonator conditions thereby may be selected such that preferably a high Q factor of the resonator is obtained, that there is a good band pass reflection response and that it corresponds with a multiple of a half-wave or quarter-wave standing wave.

In one embodiment, the reflection sensor is a free space sensor comprising a resonator and a delay line in the optical path between the radiation source and the material under test. The free space sensor may be especially suitable for some applications, as it imposes little or no limitations on the shape or other properties of the material under test. As indicated above, the material under test can be any type of material for which dielectric properties are of interest. In advantageous embodiments, the evolution of a material under study can be monitored or followed over time.

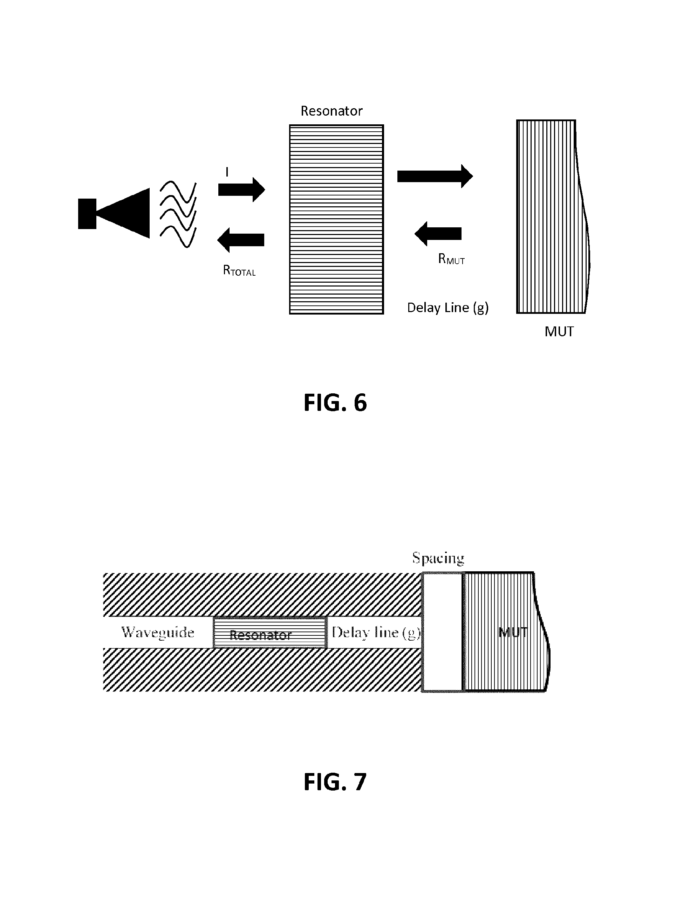

By way of illustration, an example is shown in FIG. 6.

In another embodiment, the reflection sensor is a waveguide based sensor wherein the electromagnetic radiation is directed to the material under test using a waveguide. The type of waveguide that can be used is a hollow metal pipe waveguide with various cross-sections, such as rectangular, circular, ridge waveguides, etc., parallel plate waveguides, co-planar waveguides. Alternatively transmission lines can be used such as for example coaxial cable transmission lines, micro-strip liens and strip lines, .... In embodiments based on waveguides or transmission lines the resonator can be a waveguide section or transmission line section with some dielectric object inserted with different dielectric permittivity than the rest of the waveguide or transmission line, a waveguide section or transmission line section with a different cross-section and specific length, a waveguide section or transmission line section that is linked to other waveguide through coupling windows, a combination of these implementations, etc. The characteristics of the resonator may be the same as described above. Between the resonator and the open-ended waveguide side directed to the material under test, a delay line is present. The delay line may be formed by a non-filled portion of the waveguide, between the resonator and the end of the waveguide. Alternatively, the resonator may be positioned at the edge of the open end of the waveguide pointing towards the material under test and the delay may be formed by an open region between the end of the waveguid and the material under test. In yet another embodiment, the delay line is formed by a delay line embedded in the waveguide in combination with an open space between the open-end of the waveguide and the material under test. Such a delay line may have a predetermined length, such that the distance between the resonator and the material under test is appropriate. An example of such a configuration is shown in FIG. 7.

Results

By way of illustration, embodiments of the present invention not being limited thereby, experimental results are discussed below of measurements of reflection coefficients of a matrial under test as function of chaning dielectric properties. In the example given, the change of moisture content in potatoes is measured which influence the permittivity of the potato. Such a change in complex permittivity of the potato occurs for example during a drying process. By way of illustration, the changes of the complex permittivity of the potato with moisture content is shown in table 1. These changes in complex permittivity are then measured both with a state of the art reflection measurement configuration as shown in FIG. 1 and with a reflection sensor having a configuration as shown in FIG. 6 according to an embodiment of the present inventtion.

Table 1

| Reference number | Complex permittivity | Moisture content in the potato (%) |
|---|---|---|
| P1 | 10,6180570681832 - 14,5516269032950i | 80,03 |
| P2 | 8,35803400013808 - 11,2646188096905i | 78,48 |
| P3 | 7,92880027147919 - 10,2943607414067i | 75,28 |
| P4 | 7,55582908941358 - 9,48224418009226i | 72,52 |
| P5 | 7,25948435081575 - 8,84456939153392i | 70,15 |
| P6 | 7,02138392248074 - 8,33498157452024i | 68,06 |

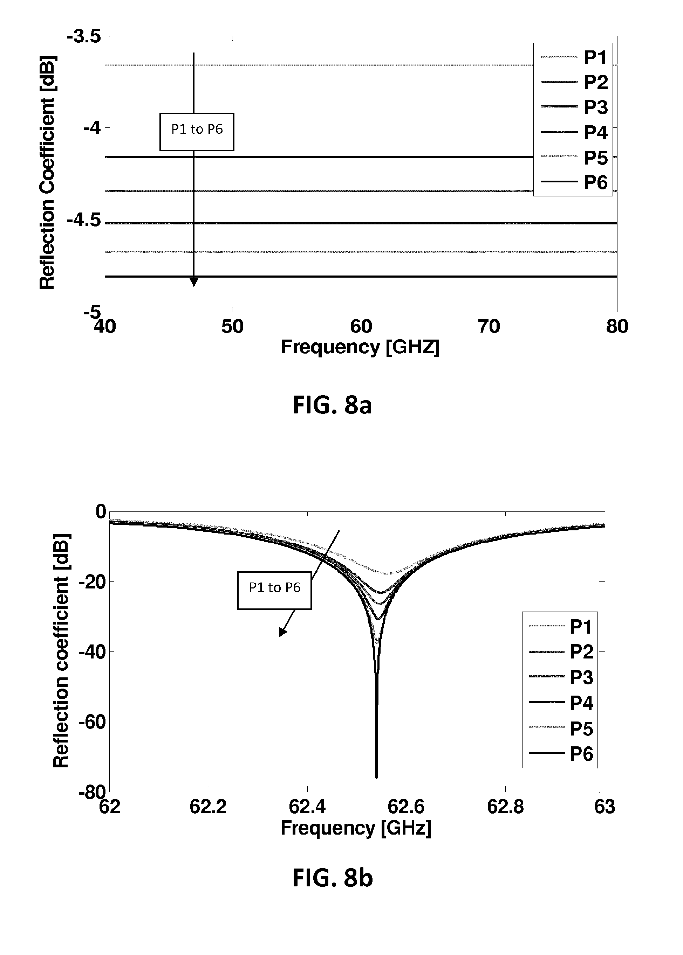

FIG. 8a illustrates the reflection coefficient that is obtained with a reflection measurement configuration according to the state of the art, shown in FIG. 1, illustrating that the differences in moisture content results in differences small changes in the reflection coefficient, e.g. smaller than 0,2 dB for some moisture changes of 2 to 3%. Nevertheless, for the same moisture changes, the differences in reflection coefficient meaured with a system according to an embodiment of the present invention results in a few dB up to more than 10 dB (depending on the specific moisture content). The latter illustrates that reflection measurements according to embodiments of the present invention result in a far better sensitivity to changes in the corresponding dielectric properties. It is to be noticed that the sensitivity of the sensor typically occurs for a selected frequency of frequency band and is not present over the full frequeny range. Nevertheless, the system can be easily tuned to such a frequency or frequency band.

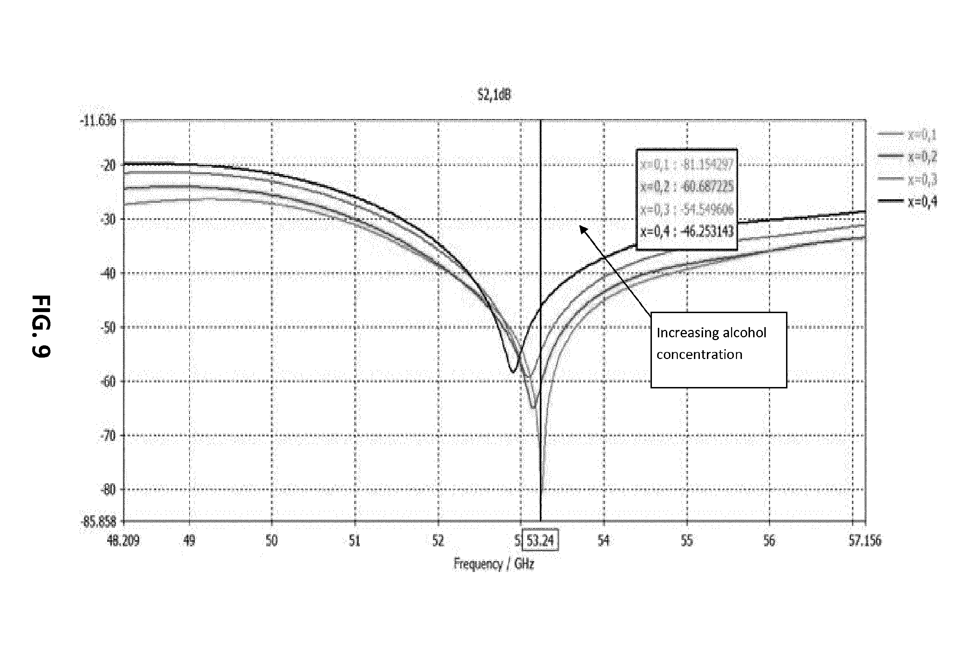

Whereas embodiments of the present invention are mainly described with reference to reflection measurements, the same principle is applicable to transmission measurements. By way of illustration, the present invention not being limited thereto, an example of how transmission measurements using a setup comprising a resonator and delay line according to embodiments of the present invention is shown in FIG. 9. FIG. 9 illustrates the effect on transmission for a liquid as function of the percentage alcohol comprised in the liquid. It can be seen that large differences can be seen in the transmission results that are obtained for alcohol concentrations between 10% and 40%.

Whereas the above example illustrates the posibbility of identifying a change in the material content, embodiments of the present invention are not limited thereto. In one example, the system could be used for sensing e.g. pH, since this also influences the reflectivity. Therefore, the present invention also relates to an optical measurement device for sensing pH or pH differences..

**Claims**

1. A sensor for sensing a reflection or transmission property of a material, the sensor comprising

   - an electromagnetic radiation input means for creating or receiving an electromagnetic radiation signal,
   - a resonator for influencing the electromagnetic radiation input signal
   - a material holder for holding the material under test
   - a delay line positioned between the resonance filter and the material holder such that the electromagnetic radiation travels in the delay line after passing the resonance filter and prior to reaching the material under test, when it is positioned in the material holder, and
   - a detection means for detecting a signal reflected by or transmitted through the material under test.

2. A sensor according to claim 1, wherein the sensor has a free space configuration.

3. A sensor according to claim 2, wherein the electromagnetic radiation input means is an electromagnetic radiation source comprising a transmitter.

4. A sensor according to claim 1, wherein the sensor has a waveguide-based configuration, wherein the electromagnetic radiation input is a waveguide portion wherein electromagnetic radiation can be coupled, wherein the resonance filter is a resonance filter embedded in the waveguide and wherein at least part of the delay line is positioned in the waveguide.

5. A sensor according to any of the previous claims, wherein the sensor is a sensor for sensing a reflection property and wherein the detection means is configured for detecting a signal reflected by the material under test.

6. A sensor according to any of the previous claims, wherein the system comprises a transceiver, functioning both as electromagnetic radiation input means and as detection means.

7. A sensor according to any of the previous claims, wherein the resonator is a high quality factor resonator, with a quality factor larger than 10.

8. A sensor according to any of the previous claims, wherein the resonator is a band pass filter.

9. A sensor according to any of the previous claims, wherein the length of the delay line is adjustable so as to be able to adjust the sensor to the material under test to be measured.

10. A sensor according to claim 9, wherein the material holder is adapted for adjusting a position of the material under test, so as to adjust the length of the delay line.

11. Use of a sensor according to any of claims 1 to 10 for detection a change in dielectric properties of a material under test.

12. Use of a sensor according to any of claims 1 to 10 for monitoring a change in material composition.

13. Use of a sensor according to any of claims 1 to 10 for monitoring a process, e.g. an industrial process.

14. Use of a sensor according to any of claims 1 to 10 for determining a pH of a material under test.

FIG. 1 – prior art

FIG. 2 – prior art

**FIG. 3 – prior art**

**FIG. 4 – prior art**

**FIG. 5**

Resonator

I

R$_{TOTAL}$

R$_{MUT}$

Delay Line (g)

MUT

## FIG. 6

Spacing

Waveguide    Resonator    Delay line (g)    MUT

## FIG. 7

FIG. 8a

FIG. 8b

**FIG. 9**

Europäisches
Patentamt

European
Patent Office

Office européen
des brevets

## EUROPEAN SEARCH REPORT

Application Number

EP 15 18 9446

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 204 670 B1 (JOSHI KALPANA KESHAV [IN]) 20 March 2001 (2001-03-20) <br> * column 1, line 1 - line 11 * <br> * column 4, line 39 - column 5, line 15 * <br> * figures * <br> ----- | 1-14 | INV. <br> G01N22/00 <br> G01R27/26 |
| A | US 2015/168314 A1 (EL MATBOULY HATEM [CA] ET AL) 18 June 2015 (2015-06-18) <br> * paragraph [0002] - paragraph [0003] * <br> * paragraph [0006] - paragraph [0009] * <br> ----- | 1-14 | |
| A | WO 2013/164627 A1 (UNIV HERIOT WATT [GB]) 7 November 2013 (2013-11-07) <br> * page 1, line 4 - line 8 * <br> * page 3, line 31 - page 4, line 17 * <br> * page 6, line 18 - page 8, line 5; figure 1 * <br> ----- | 1-14 | |
| A | GB 2 471 024 A (WIVENHOE TECHNOLOGY LTD [GB]) 15 December 2010 (2010-12-15) <br> * page 1, line 7 - line 29 * <br> * page 6, line 3 - line 28; figure 1 * <br> ----- | 1-14 | TECHNICAL FIELDS SEARCHED (IPC) |
| A | US 3 851 244 A (MOUNCE G) 26 November 1974 (1974-11-26) <br> * column 1, line 1 - line 24 * <br> * column 3, line 18 - line 62; figures * <br> ----- | 1-14 | G01N <br> G01R |

The present search report has been drawn up for all claims

| Place of search | Date of completion of the search | Examiner |
|---|---|---|
| The Hague | 21 March 2016 | Savage, John |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 18 9446

This annex lists the patent family members relating to the patent documents cited in the above-mentioned European search report.
The members are as contained in the European Patent Office EDP file on
The European Patent Office is in no way liable for these particulars which are merely given for the purpose of information.

21-03-2016

| Patent document cited in search report | | Publication date | Patent family member(s) | | Publication date |
|---|---|---|---|---|---|
| US 6204670 | B1 | 20-03-2001 | US 6204670 B1 <br> US 2001030543 A1 | | 20-03-2001 <br> 18-10-2001 |
| US 2015168314 | A1 | 18-06-2015 | NONE | | |
| WO 2013164627 | A1 | 07-11-2013 | AU 2013255647 A1 <br> CA 2871984 A1 <br> CN 104704351 A <br> EP 2844986 A1 <br> JP 2015517651 A <br> US 2015097561 A1 <br> WO 2013164627 A1 | | 27-11-2014 <br> 07-11-2013 <br> 10-06-2015 <br> 11-03-2015 <br> 22-06-2015 <br> 09-04-2015 <br> 07-11-2013 |
| GB 2471024 | A | 15-12-2010 | NONE | | |
| US 3851244 | A | 26-11-1974 | NONE | | |

EPO FORM P0459

For more details about this annex : see Official Journal of the European Patent Office, No. 12/82